# EUROPÄISCHE PATENTANMELDUNG

(11) **EP 4 554 095 A1**
(43) Veröffentlichungstag der Anmeldung: **14.05.2025**
(21) Anmeldenummer: 24190813.6
(22) Anmeldetag: 25.07.2024
(51) Int. Cl.: H03K 17/97, H03K 17/972

(54) **BEDIENVORRICHTUNG FÜR EIN KRAFTFAHRZEUG**

(30) Priorität: 07.11.2023 DE 102023130716
(71) Anmelder: HUF Hülsbeck & Fürst GmbH & Co. KG, 42551 Velbert (DE)
(72) Erfinder: Chabrowski, Christian, 45472 Mülheim (DE)
(74) Vertreter: Zenz Patentanwälte Partnerschaft mbB

(57) **Zusammenfassung**

Bedienvorrichtung für ein Kraftfahrzeug mit einem Gehäuse (1), in dem mindestens zwei induktive Sensorbereiche (5, 6) angeordnet sind, denen jeweils ein metallisches Target (5a, 6a) zugeordnet ist. Eine Krafteinwirkung auf Betätigungsbereiche (7a, 7b) führt zu einer Abstandsänderung zwischen dem zugeordneten induktiven Sensorbereich (5, 6) und seinem zugeordneten Target (5a, 6a).

Die induktiven Sensorbereiche (5, 6) sind über Signalleitungen (4a, 4b) miteinander und über gemeinsame Kontakte in Parallelschaltung mit einer Steuerschaltung (4) gekoppelt.

Die induktiven Sensorbereiche (5, 6) sind derart zueinander ausgerichtet und die Signalleitungen (4a, 4b) derart geführt, dass eine Annäherung eines ersten Targets (5a, 6a) relativ zu dem ersten Sensorbereich zu einem Signalanstieg an der Steuerschaltung führt, während eine Annäherung eines zweiten Targets (5a, 6a) relativ zu dem zweiten induktiven Sensorbereich (5, 6) zu einem Signalabfall führt.

## Beschreibung

Die Erfindung betrifft eine Bedienvorrichtung für ein Kraftfahrzeug. Insbesondere betrifft die Erfindung eine Bedienvorrichtung für ein Kraftfahrzeug, bei der in dem Gehäuse der Bedienvorrichtung wenigstens zwei induktive Sensorbereiche angeordnet sind. Jedem der induktiven Sensorbereiche ist jeweils ein metallisches Target zugeordnet, welches jeweils beabstandet zu dem zugeordneten induktiven Sensorbereich in dem Gehäuse angeordnet ist.

Induktive Sensoren, auch induktive Näherungsschalter oder Initiatoren genannt, sind in der Automatisierungs- und Verfahrenstechnik und in der Automobilindustrie weit verbreitet und werden für verschiedene Anwendungen in Fahrzeugen eingesetzt. Sie nutzen das Prinzip der Induktion, um Änderungen in einem elektrischen Feld zu erfassen, die durch die Anwesenheit von Metall oder elektrisch leitfähigen Materialien verursacht werden. Induktive Sensoren arbeiten nach dem Prinzip der Impedanzänderung, die durch Wirbelströme in einem leitfähigen Target verursacht wird. Der Sensor wird von einem Oszillator angeregt, wodurch ein elektromagnetisches Feld erzeugt wird, das mit dem (galvanisch entkoppelten) Target koppelt. Eine Signalverarbeitungselektronik erfasst die Impedanzänderung, wenn sich der Abstand zwischen Sensor und Target ändert, und wandelt sie in ein nutzbares Verschiebungssignal um. Die Verarbeitung der Signale kann mithilfe von einem Schaltkreis erfolgen, welche z.B. von den einer Nutzung oder Kombination der folgenden Schaltkreistypen abgeleitet ist: Colpitts-Schaltung, Phasenschaltung und Brückenschaltung (z.B. Maxwell-Brücke).

Induktive Sensoren werden häufig zur Erfassung der Raddrehzahl in modernen Fahrzeugen eingesetzt. Diese Sensoren befinden sich in der Nähe der Räder und messen mittels Induktion die Anzahl der Umdrehungen pro Minute. Diese Information ist entscheidend für das Antiblockiersystem (ABS), die Antriebsschlupfregelung und andere Fahrzeugstabilitätssysteme. Induktive Sensoren können auch verwendet werden, um den Abstand zwischen einem Fahrzeug und einem Hindernis zu messen. Diese Sensoren werden häufig in Einparkhilfesystemen eingesetzt, um den Fahrer beim sicheren Einparken zu unterstützen und Kollisionen zu vermeiden. Induktive Sensoren können auch in Fahrzeugtüren und Kofferraumdeckeln eingesetzt werden, um festzustellen, ob diese richtig geschlossen sind.

Induktive Sensoren haben den Vorteil, dass sie berührungslos arbeiten und kaum anfällig für Verschleiß und Verschmutzung sind. Sie zeichnen sich durch hohe Zuverlässigkeit aus und arbeiten berührungslos, kontakt- und rückwirkungsfrei.

Das induktive Element eines solchen Sensors ist eine Leiterspule, die bei Stromfluss ein Magnetfeld erzeugt. Das Magnetfeld wirkt in einem räumlich begrenzten Bereich einer aktiven Schaltzone. Wird ein Target (z.B. eine Metallplatte) in diesen Bereich gebracht, so wird das Magnetfeld deformiert oder gedämpft. Durch die Änderung des Magnetfeldes erfährt die Spule eine Änderung der Impedanz.

Im Rahmen dieser Anmeldung wird der Begriff "Sensorbereich" verwendet, um die Ausbildung eines induktiven Elements zu beschreiben. Der Begriff umfasst also wenigstens ein induktives Element, kann aber noch weitere bauliche Komponenten oder mechanische Strukturen aufweisen. Dieser Begriff wird in Abgrenzung zum Begriff "Sensor" verwendet, da ein Sensor im Kontext dieser Anmeldung mehrere, getrennt auswertbare Sensorbereiche aufweisen kann. Ein Sensorbereich kann insbesondere eine Sensorfläche oder ein integriertes induktives Bauelement umfassen, welches in dem Sensorbereich angeordnet wird. Das zum Sensorbereich zugeordnete Target, welches mit dem induktiven Element wechselwirkt ist in räumlicher Nachbarschaft zum Sensorbereich angeordnet, so dass es die Induktivität des induktiven Elements im Sensorbereich auswertbar beeinflusst.
Sowohl die induktiven Sensorbereiche als auch die Targets sind in der Bedienvorrichtung so angeordnet, dass eine Krafteinwirkung auf Bedienbereiche des Gehäuses, die im Erfassungsbereich eines der Sensorbereiche liegen, eine Abstandsänderung zwischen dem zugeordneten induktiven Sensorbereich und seinem zugeordneten Target und damit eine Änderung der Induktivitäten des jeweiligen induktiven Sensorbereichs zur Folge hat. Eine Krafteinwirkung kann das Gehäuse selbst oder besonders verformbar gestaltete Bereiche, z.B. weiche Bauteile, die im Gehäuse angeordnet sind, verformen. Die Abstandsänderung kann dadurch bewirkt werden, dass das Target am Gehäuse selbst befestigt ist und durch die Verformung des Gehäuses im Wirkbereich auf den zugeordneten induktiven Sensorbereich zu oder von diesem weg bewegt wird. Alternativ kann prinzipiell auch der Sensorbereich selbst durch die Krafteinwirkung bewegt werden, wobei entscheidend ist, dass ein Bedienvorgang mit Krafteinwirkung auf die Bedieneinrichtung zu einer Abstandsänderung zwischen Target und zugeordnetem induktiven Sensorbereich führt. Die induktiven Sensorbereiche werden über eine Steuerschaltung angesteuert und abgefragt, wobei verschiedene Verfahren zur Auswertung der jeweiligen Induktivitäten in den Sensorbereichen in Frage kommen. So kann z.B. das analoge Ausgangssignal des Sensorbereichs verwendet werden, das eine induzierte Spannung in Abhängigkeit von der Bewegung eines metallischen Elements relativ zum Sensorbereich anzeigt. Induktive Sensoren können auch anhand ihres Frequenzverhaltens bei Anregung ausgewertet werden. Wenn sich ein metallisches Objekt in der Nähe des Sensors befindet, ändert sich die Schwingungsfrequenz, da sich die Induktivität ändert. Die Frequenzänderung wird gemessen und kann zur Metalldetektion oder zur Positionsbestimmung genutzt werden.
Auch die Änderung der Phasenverschiebung eines Signals kann zur Auswertung sich ändernder Induktivitäten genutzt werden. Die Phasenverschiebung ändert sich, wenn sich ein metallisches Objekt bewegt oder wenn sich die Induktivität eines Sensorbereichs ändert. Auf die verschiedenen Auswerteverfahren wird an dieser Stelle nicht weiter eingegangen, da die Auswertung induktiver Sensoren grundsätzlich bekannt ist.

Induktive Sensorbereiche sind in der Regel mit einer jeweils zugeordneten Steuerschaltung gekoppelt, so dass die Steuerschaltung die Sensorbereiche sequenziell oder auch zeitlich parallel abfragt. Dies ist zum einen zeitaufwendig und erfordert eine Steuerschaltung mit einer entsprechenden Anzahl von Steuer- und Signalkontakten.

Aufgabe der Erfindung ist es, eine Bedienvorrichtung bereitzustellen, die den bewährten Aufbau der induktiven Sensorbereiche mit reduzierter Auswertekomplexität und optimierter Auswertezeit ermöglicht.

Diese Aufgabe wird durch eine Bedienvorrichtung mit den Merkmalen des Patentanspruchs 1 gelöst.

Die erfindungsgemäße Bedienvorrichtung weist mindestens zwei induktive Sensorbereiche auf, die mit einer gemeinsamen Ansteuerschaltung gekoppelt sind. Die induktiven Sensorbereiche sind über Signalleitungen miteinander und über gemeinsame Kontakte mit der gemeinsamen Steuerschaltung derart gekoppelt, dass sich eine Parallelschaltung der induktiven Sensorbereiche zu der gemeinsamen Steuerschaltung ergibt. Dabei werden die Signale der induktiven Sensorbereiche über gemeinsame Signalleitungen erfasst.

Bei dieser erfindungsgemäßen Ausgestaltung und Verschaltung werden die induktiven Sensorbereiche gegenüber der Steuerschaltung nicht durch eine getrennte Signalkopplung als getrennte Sensorbereiche erkennbar gemacht, sondern die Steuerschaltung nimmt die jeweils getrennt ausgebildeten und mit jeweiligen Bedienbereichen versehenen induktiven Sensorbereiche einheitlich wahr. Durch die Parallelschaltung der induktiven Sensorbereiche ergibt sich eine resultierende Gesamtinduktivität, die nach den bekannten Prinzipien der Parallelschaltung von Induktivitäten berechnet wird.

Erfindungsgemäß sind bei der Parallelschaltung die induktiven Sensorbereiche derart zueinander ausgerichtet und die Signalleitungen zwischen den induktiven Sensorbereiche derart geführt, dass eine Annäherung eines ersten Targets gegenüber dem zugeordneten ersten induktiven Sensor zu einem Signalanstieg an der Steuerschaltung führt, während eine Annäherung eines zweiten Targets gegenüber dem zugeordneten zweiten induktiven Sensor zu einem Signalabfall führt.

Während die induktiven also von der Steuerschaltung als einheitliche Induktivitäten wahrgenommen werden, unterscheiden sie sich hinsichtlich ihrer Signalerzeugung. Dies kann insbesondere dadurch erreicht werden, dass die induktiven Sensorbereiche hinsichtlich des durch sie fließenden Stroms und des korrespondierenden Magnetfelds räumlich unterschiedlich ausgerichtet sind. Für die Steuerschaltung ist dies an der Richtung der Signaländerung erkennbar, d.h. an der Unterscheidung zwischen einem Signalanstieg und einem Signalabfall. Die Steuerschaltung kann somit anhand der Signaländerung den auslösenden induktiven Sensor identifizieren, obwohl dieser mit dem anderen induktiven Sensor parallelgeschaltet ist und eine gemeinsame Induktivität bildet. Anhand der Signaländerung, die durch die unterschiedliche räumliche Orientierung der induktiven Sensorbereiche zum jeweils zugeordneten Ziel hervorgerufen wird, ist es möglich, die Signale von zwei induktiven Sensorbereichen in einer einheitlichen, simultanen Messung zu erfassen und zu differenzieren. Dies spart zum einen Zeit und reduziert zum anderen den Aufwand bei der Auswertung in der Steuerschaltung.

Die Umkehrung der Signalrichtung, d.h. die Erzeugung eines Signalanstiegs im ersten induktiven Sensor bei Annäherung des ihm zugeordneten Targets und eines Signalabfalls im zweiten induktiven Sensor bei Annäherung des ihm zugeordneten Targets, wird dadurch erreicht, dass durch die räumliche Anordnung und Orientierung, die in den jeweiligen induktiven erzeugten Magnetfeldern unterschiedlich zu den Targets ausgerichtet sind. Durch die unterschiedliche Ausrichtung der Spulen in den induktiven Sensorbereichen bei unterschiedlicher Orientierung wird - wenn man das Bild der Feldlinien für das Magnetfeld verwendet - z.B. das Target für den ersten Sensor bei Annäherung entgegen den Feldlinien bewegt, während es beim zweiten Sensor (aufgrund der Parallelschaltung) bei Annäherung in Richtung der Feldlinien bewegt wird. Dies wirkt sich auf die nachgeschaltete Signalauswertung aus, so dass eine Unterscheidung zwischen den verschiedenen möglich ist, auch wenn diese durch eine einheitliche Ansteuerung in der Parallelschaltung angesteuert werden und auch wenn diese gleiche Einzelinduktivitäten aufweisen.

In einer bevorzugten Ausführungsform der Erfindung sind die induktiven Sensorbereiche mit gleicher räumlicher Orientierung auf einer gemeinsamen Leiterplatte angeordnet und die Signalleitungen zwischen den Sensorbereichen so geführt, dass die induktiven Sensorbereiche in entgegengesetzter Richtung zueinander gespeist werden.

Bei dieser Ausführungsform wird die Magnetfeldausrichtung der Induktivitäten durch eine gegensinnige Bestromung der induktiven Sensorbereiche erreicht. Dies ermöglicht eine besonders gleichmäßige und einfache Platzierung der Sensorbereiche auf der Leiterplatte und die erfindungsgemäße Funktionalität der Umkehrung der Magnetfelder wird durch die Führung der Signalleitungen erreicht.

In einer Weiterbildung der Erfindung sind die induktiven Sensorbereiche jeweils als gedruckte Leiterspiralen auf einer gemeinsamen Leiterplatte aufgedruckt, wobei eine Signalleitung das innere Ende der Leiterspiralen des ersten induktiven Sensors mit dem äußeren Ende der Leiterspiralen des zweiten induktiven Sensors koppelt.

Diese Anordnung ist besonders einfach in der Herstellung, da die induktiven Sensorbereiche aus gedruckten Leiterbahnen bestehen und die unterschiedliche Ausrichtung des Magnetfeldes allein durch den Herstellungs- und Druckprozess der Platine bewirkt wird.

In einer bevorzugten Ausgestaltung der Erfindung sind die induktiven Sensorbereiche jeweils mit gleichen Induktivitäten ausgebildet.

Während die Erfindung grundsätzlich auch wirksam ist, wenn die induktiven Sensorbereiche unterschiedliche Induktivitäten aufweisen, ist die Auswertung hinsichtlich Signalanstieg und Signalabfall besonders einfach, wenn einheitliche Induktivitäten vorliegen. Auch die Herstellung einer erfindungsgemäßen Bedienvorrichtung erfordert in diesem Fall weniger unterschiedliche Bauteile.

In einer weiteren Ausgestaltung der Erfindung sind mehr als zwei induktive Sensorbereiche vorgesehen, die in einer Parallelschaltung mit der gemeinsamen Ansteuerschaltung gekoppelt sind, so dass diese die Signale der induktiven Sensorbereiche über die gleichen Signalleitungen erfasst. Dabei ist eine erste Gruppe von induktiven Sensorbereichen so angeordnet und ausgerichtet, dass eine Annäherung der Targets relativ zu den jeweils zugeordneten induktiven Sensorbereichen der ersten Gruppe zu einem Signalanstieg an der Steuerschaltung führt, während eine zweite Gruppe von induktiven Sensorbereichen so angeordnet und ausgerichtet ist, dass eine Annäherung der Targets relativ zu den zugeordneten induktiven Sensorbereichen der zweiten Gruppe zu einem Signalabfall an der Steuerschaltung führt.

Bei dieser Anordnung werden induktive Sensorbereiche zu Gruppen zusammengefasst, um z.B. mehrere Bedienbereiche einheitlich auszuwerten. Dadurch bleibt der Auswerteaufwand an der Steuereinrichtung gering.

In einer bevorzugten Ausgestaltung der zuvor beschriebenen Bedienvorrichtung weisen die induktiven Sensorbereiche der ersten Gruppe jeweils eine geringere Induktivität auf als die induktiven Sensorbereiche der zweiten Gruppe.

Die Ausgestaltung mit unterschiedlich großen Induktivitäten ermöglicht neben der Differenzierung nach Signalanstieg und Signalabfall auch eine Differenzierung nach der Signalhöhe, so dass die Betätigungen in den verschiedenen Gruppen noch besser unterschieden werden können.

Die Erfindung wird nun anhand eines Ausführungsbeispiels näher erläutert, das in den beigefügten Zeichnungen dargestellt ist.
Figur 1 zeigt schematisch einen Fahrzeugtürgriff, in dem eine Bedienvorrichtung gemäß dem ersten Ausführungsbeispiel aufgenommen ist.
Figur 2 zeigt schematisch die Bedienvorrichtung in einer Draufsicht.
Figur 3 zeigt in schematischer Weise die Signalverläufe bei Betätigung der Bedienvorrichtung gemäß dem ersten Ausführungsbeispiel.

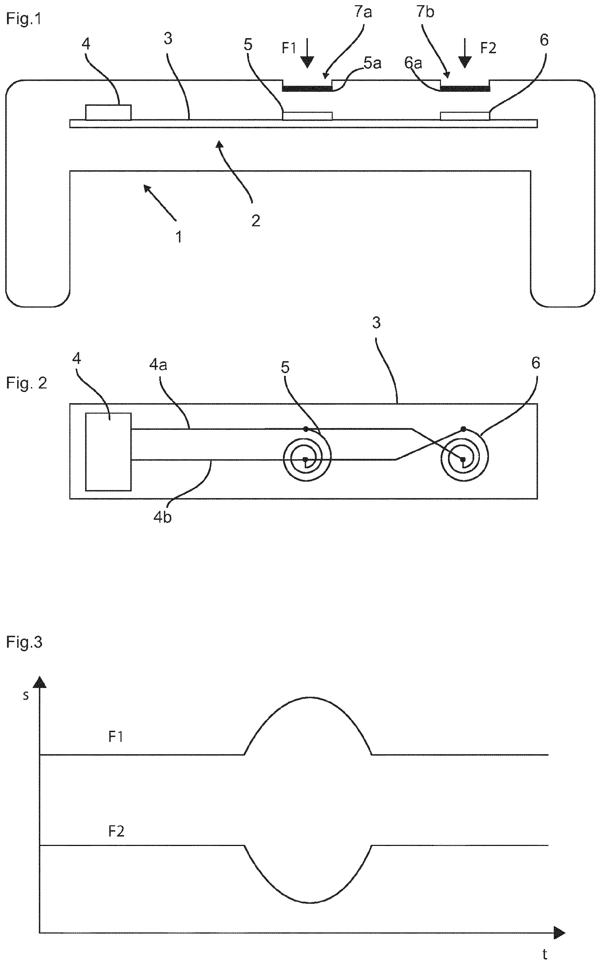

In Figur 1 ist ein Fahrzeugtürgriffgehäuse 1 gezeigt, in dessen Innenraum eine Bedienvorrichtung 2 gemäß dem ersten Ausführungsbeispiel aufgenommen ist. Die Bedienvorrichtung kann im Inneren des Gehäuses in entsprechende Aufnahmen eingeklebt oder eingeclipst oder auf andere Weise im Inneren des Gehäuses stabil befestigt sein. Es sind zwei Bedienbereiche 7a und 7b vorgesehen, die im Gehäuse des Fahrzeugtürgriffgehäuses 1 ausgebildet sind, wobei die Bedienbereiche 7a und 7b für einen Benutzer optisch und/oder haptisch identifizierbar sind. Sie können insbesondere aus einem weichen, verformbaren Material gebildet sein. Auf der Unterseite der Bedienbereiche 7a und 7b, d.h. auf der der Bedienvorrichtung 2 zugewandten Seite, sind Targets 5a und 6a angeordnet, die zusammen mit den darunter angeordneten spiralförmigen Leiterspulen 5 und 6 jeweils einen induktiven Sensor 5,5a bzw. 6,6a bilden.

Die Targets 5a und 6a sind derart mit den Bedienbereichen 7a und 7b gekoppelt, dass sie bei Krafteinwirkung durch eine der Kräfte F1 oder F2 in Richtung der Leiterspulen 5 und 6 bewegt werden. Die Targets können z.B. auf der Innenseite der verformbaren Gehäuseabschnitte der Bedienbereiche 7a und 7b aufgeklebt sein oder aus einer Beschichtung dieser Bereiche bestehen. Die Targets sind dabei aus einem metallischen Werkstoff gebildet.

Die Bedienvorrichtung 2 weist eine Platine 3 auf, auf der eine Steuerschaltung 4 mit einem Mikrocontroller sowie die spiralförmigen Leiterspulen 5 und 6 als gedruckte Leiterbahnen angeordnet sind. In Figur 2 ist gezeigt, dass die Leiterspulen 5 und 6 spiralförmig auf der Platine 3 in deren Ebene angeordnet sind. Die Steuerschaltung 4 ist über elektrische Leitungen 4a und 4b mit den Induktivitäten der spiralförmigen Leiterspulen 5 und 6 gekoppelt. Dabei sind die Leitungen 4a und 4b zwischen den spiralförmigen Leiterspulen 5 und 6 derart gekreuzt, dass ein äußeres Ende der spiralförmigen Leiterspule 5 mit dem inneren Ende der spiralförmigen Leiterspulen 6 gekoppelt ist. Andererseits ist das innere Ende der spiralförmigen Leiterspulen 5 mit dem äußeren Ende der spiralförmigen Leiterspulen 6 gekoppelt.

Diese Anordnung hat zur Folge, dass beim Durchströmen der Leitungen 4a und 4b der Aufbau des Magnetfeldes der Spiralspulen 5 und 6 immer einander entgegengesetzt ist. Die Ansteuerung und Auswertung der Induktivitäten in der Steuerschaltung 4 erfolgt so, dass eine Annäherung eines Targets entgegen den Magnetfeldlinien zu einer anderen entgegengesetzten Signaländerung führt als eine Annäherung eines Targets in Richtung der Magnetfeldlinien einer Induktivität. Wird also eine Kraft F1 auf einen Bedienbereich 7a ausgeübt, so nähert sich das Target 5a der spiralförmigen Leiterspule 5. Wirkt eine Kraft F2 auf den Bedienbereich 7b, so wird das Target 6a der spiralförmigen Leiterspule 6 angenähert. Obwohl die Annäherung in beiden Fällen in ihrer Richtung identisch ist, sind die Magnetfelder der spiralförmigen Leiterspule 5 und der spiralförmigen Leiterspule 6 einander entgegengerichtet, so dass die Steuerschaltung 4 an der Signaländerung erkennen kann, ob die Kraft F1 oder die Kraft F2 gewirkt hat, also insbesondere ob der Bedienbereich 7a oder der Bedienbereich 7b mit einer Betätigungskraft beaufschlagt wurde.

In Figur 3 ist beispielhaft dargestellt, wie sich eine Betätigung in einem Bedienbereich 7a von einer Betätigung in einem Bedienbereich 7b unterscheidet, nämlich einerseits in einem Signalanstieg bei Betätigung mit der Kraft F1, während gleichzeitig eine Kraft F2 zu einem Signalabfall führen würde. Auf diese Weise ist es der Steuerschaltung 4 möglich, trotz der Parallelschaltung von zwei Induktivitäten die Auslösung des ersten induktiven Sensors 5,5a von der Auslösung des zweiten induktiven Sensors 6,6a zu unterscheiden.

## Patentansprüche

1. Bedienvorrichtung für ein Kraftfahrzeug, mit einem Gehäuse (1), in dem wenigstens zwei induktive Sensorbereiche (5, 6) angeordnet sind,
wobei jedem der induktiven Sensorbereiche (5, 6) jeweils ein metallisches Target (5a, 6a) zugeordnet ist, welches beabstandet zu dem jeweils zugeordneten induktiven Sensorbereich (5, 6) angeordnet ist,
wobei die induktiven Sensorbereiche (5, 6) und die zugeordneten Targets (5, 6) derart in dem Gehäuse (1) angeordnet sind, dass eine Krafteinwirkung auf Bedienbereiche (7a, 7b), die den induktiven Sensorbereichen (5, 6) jeweils zugeordnet sind, zu einer Abstandsänderung zwischen dem zugeordneten induktiven Sensorbereich (5, 6) und seinem zugeordneten Target (5a, 6a) führt, und damit zu einer Änderung einer Induktivität des jeweiligen induktiven Sensorbereichs,
**dadurch gekennzeichnet,**
**dass** die wenigstens zwei induktiven Sensorbereiche (5, 6) mit einer gemeinsamen Steuerschaltung (4) gekoppelt sind,
wobei die induktiven Sensorbereiche (5, 6) über Signalleitungen (4a, 4b) miteinander und über gemeinsame Kontakte mit der gemeinsamen Steuerschaltung (4) derart gekoppelt sind, dass die induktiven Sensorbereiche (5, 6) in einer Parallelschaltung mit der gemeinsamen Steuerschaltung (4) gekoppelt sind, so dass diese die Signale der induktiven Sensorbereiche (5, 6) über dieselben Signalleitungen erfasst,
wobei die induktiven Sensorbereiche (5, 6) derart zueinander ausgerichtet sind und die Signalleitungen (4a, 4b) zwischen den induktiven Sensorbereichen (5, 6) derart geführt sind, dass eine Annäherung eines ersten Targets (5a, 6a) gegenüber dem zugeordneten ersten induktiven Sensorbereich in einem Signalanstieg an der Steuerschaltung resultiert, während eine Annäherung eines zweiten Targets (5a, 6a) gegenüber dem zugeordneten zweiten induktiven Sensorbereich (5, 6) in einem Signalabfall resultiert.

2. Bedienvorrichtung nach Anspruch 1, wobei die induktiven Sensorbereiche (5, 6) mit derselben Raumorientierung auf einer gemeinsamen Platine (3) angeordnet sind und die Signalleitungen (4a, 4b) zwischen den Sensorbereichen (5, 6) derart geführt sind, dass die induktiven Sensorbereiche in zueinander entgegengesetzter Richtung gespeist werden.

3. Bedienvorrichtung nach Anspruch 2, wobei die induktiven Sensorbereiche (5, 6) jeweils eine gedruckte Leiterspirale als Induktionsspule aufweisen, wobei eine Signalleitung 4a, 4b) das innere Ende der Leiterspirale des ersten induktiven Sensorbereichs und das äußere Ende der Leiterspirale des zweiten induktiven Sensorbereichs koppelt.

4. Bedienvorrichtung nach einem der vorangehenden Ansprüche, wobei die induktiven Sensorbereiche jeweils die gleiche Induktivität aufweisen.

5. Bedienvorrichtung nach einem der Ansprüche 1 bis 3, wobei mehr als zwei induktive Sensorbereiche vorgesehen sind, die in einer Parallelschaltung mit der gemeinsamen Steuerschaltung gekoppelt sind, so dass diese die Signale der induktiven Sensorbereiche über dieselben Signalleitungen erfasst, wobei eine erste Gruppe von induktiven Sensorbereichen so angeordnet und ausgerichtet ist, dass eine Annäherung der Targets gegenüber den zugeordneten induktiven Sensorbereichen der ersten Gruppe in einem Signalanstieg an der Steuerschaltung resultiert, eine zweite Gruppe von induktiven Sensorbereichen so angeordnet und ausgerichtet ist, dass eine Annäherung der Targets gegenüber den zugeordneten induktiven Sensorbereichen der zweiten Gruppe in einem Signalabfall an der Steuerschaltung resultiert.

6. Bedienvorrichtung nach Anspruch 5, wobei die induktiven Sensorbereiche der ersten Gruppe jeweils eine geringere Induktivität aufweisen als die induktiven Sensorbereiche der zweiten Gruppe.
